# EUROPÄISCHE PATENTANMELDUNG

(11) **EP 1 193 768 A1**
(43) Veröffentlichungstag der Anmeldung: **03.04.2002**
(21) Anmeldenummer: 00810899.5
(22) Anmeldetag: 29.09.2000
(51) Int. Cl.: H01L 29/749, H01L 23/34

(54) **Verfahren zum Betreiben eines abschaltbaren Leistungshalbleiterbauelements sowie Vorrichtung zur Durchführung des Verfahrens**

(71) Anmelder: ABB Semiconductors AG, 5400 Baden (CH)
(72) Erfinder: Oedegard, Björn, 5300 Turgi (CH); Dalibor, Thomas, 5000 Aarau (CH); Weber, Andrè, 4600 Olten (CH)
(74) Vertreter: ABB Patent Attorneys

(57) **Zusammenfassung**

Bei einem Verfahren zum Betreiben eines eine Anode (A) und eine Kathode (K) aufweisenden, über ein Gate (G) abschaltbaren Leistungshalbleiterbauelements (10, 11), insbesondere eines GCTs (10) bzw. IGCTs (11), bei welchem Leistungshalbleiterbauelement (10, 11) die Sperrschichttemperatur (Tⱼ) einen Arbeitstemperaturbereich mit einer Minimaltemperatur aüfweist, der den Arbeitstemperaturbereiches des Leistungshalbleiterbauelements (10, 11) bestimmt, wird ein Erweiterung des Arbeitstemperaturbereichs dadurch erreicht, dass vor dem ersten Einschalten des Leistungshalbleiterbauelements (10, 11) die Sperrschichttemperatur (Tⱼ) durch Erzeugung von Wärme im Leistungshalbleiterbauelement (10, 11) selbst erhöht wird.

## Beschreibung

### TECHNISCHES GEBIET

Die vorliegende Erfindung bezieht sich auf das Gebiet der Leistungshalbleitertechnik. Sie betrifft ein Verfahren zum Betreiben eines eine Anode und eine Kathode aufweisenden, über ein Gate abschaltbaren Leistungshalbleiterbauelements gemäss dem Oberbegriff des Anspruchs 1, sowie eine Vorrichtung zur Durchführung des Verfahrens.

### STAND DER TECHNIK

In der Leistungselektronik bei Umrichtern, Antrieben oder dgl. haben sich in den vergangenen Jahren verschiedene Arten von Leistungshalbleiterbauelementen bewährt, die sich durch hohe abschaltbare Ströme, hohe Sperrspannungen und eine einfache Ansteuerung auszeichnen. Zu diesen Bauelementen gehören u.a. der IGBT (Insulated Gate Bipolar Transistor) und der GTO (Gate Turn Off Thyristor). Obgleich beide Bauelementtypen hinsichtlich Leistungsbereich und Schaltverhalten ständig weiterentwickelt werden, haben sie aufgrund ihres Aufbaus und ihrer Funktionsweise gewisse Nachteile. Beim IGBT zählt dazu der vergleichsweise hohe Durchlasswiderstand, beim GTO der Abschaltvorgang, bei dem ein instabiler Uebergang vom leitenden (Thyristor-)Zustand in den sperrenden (Transistor-)Zustand existiert, der zu vergleichsweise hohen Schaltverlusten führt und eine umfangreiche äussere Schutzbeschaltung notwendig macht.

Um die Vorteile des GTO (niedriger Durchlasswiderstand, hohe Schaltleistung) ohne die Nachteile des instabilen Uebergangs beim Abschalten zu erzielen, hat man bereits früher vorgeschlagen, GTOs "hart" anzusteuern, d.h. durch eine extrem niederdinduktive Ansteuerung bzw. grosse Steilheit des Gatestromanstiegs (mehrere 1000 A/µs) den Kathodenstrom vollständig auf das Gate zu kommutieren (und damit in den Transistorzustand überzugehen), bevor die Anodenspannung ansteigt. Hierdurch wird der instabile Uebergangsbereich vermieden und ein sicheres Abschalten ohne äussere Schutzbeschaltung ermöglicht. Da bei der Dimensionierung des zugehörigen Halbleiterwafers nicht länger auf das Schaltverhalten Rücksicht genommen werden muss, kann die Siliziumscheibe zur Verringerung der Durchlassverluste dünner ausgelegt werden. Man kommt so zu einer neuen Klasse von abschaltbaren Leistungshalbleiterbauelementen, die mit GCT (Gate Commutated Thyristor) oder - wenn das Bauelement und die niederinduktive Ansteuerung zu einer baulichen Einheit zusammengefügt werden - mit IGCT (Integrated Gate Commutated Thyristor) bezeichnet werden.

Einzelheiten über Aufbau, Funktionsweise und Entwicklungsstand der GCTs bzw. IGCTs lassen sich z.B. aus dem Artikel von Harold M. Stillman, "IGCTs - megawatt power switches for medium-voltage applications", ABB Review 3/97 (1997), oder aus dem Artikel von Peter K. Steiner et al., "IGCT - eine neue zukunftsweisende Technik für kostengünstige Hochleistungs-Umrichter", ABB Technik 5/98 (1998), entnehmen. Ein kommerziell erhältlicher IGCT ist von der Anmelderin beispielsweise unter der Typbezeichnung 5SHY 35L4502 (Datenblatt Doc. No. 5SYA 1218-04 Feb. 99) bekannt.

Die IGCTs sind für den Einsatz in Stromrichtern bis zu einer minimalen Sperrschichttemperatur Tⱼ, d.h., bis zu einer minimalen Temperatur des sperrenden pn-Uebergangs, spezifiziert. Diese Grenze bestimmt meistens auch die minimale Umgebungstemperatur des Stromrichters, da beim Aufstarten der Anlage die Sperrschichttemperatur Tⱼ gleich der Umgebungstemperatur ist. Für den o.g. IGCT-Typ 5SHY 35L4502 liegt der Arbeitsbereich der Sperrschichttemperatur Tⱼ zwischen 0°C und 115 °C und der Arbeitsbereich der Umgebungstemperatur zwischen 0°C und 60°C. Liegt die Umgebungstemperatur unterhalb der spezifizierten minimalen Temperatur (im Beispiel unterhalb 0°C), muss das System vor dem Aufstarten vorgeheizt werden, bis die minimale spezifizierte Sperrschichttemperatur Tⱼ erreicht wird. Dies kann beispielsweise durch Vorheizen des durch das System fliessenden Kühlwassers erreicht werden. Hierzu wären jedoch umfangreiche zusätzliche Installationen erforderlich.

### DARSTELLUNG DER ERFINDUNG

Es ist daher Aufgabe der Erfindung, ein Verfahren und eine Vorrichtung anzugeben, mit denen ein mit der Temperatur unterhalb des zulässigen Arbeitstemperaturbereiches liegendes Leistungshalbleiterbauelement auf einfache und sichere Art und ohne grosse zusätzliche Installationen vor der Aufnahme des Betriebes soweit vorgeheizt werden kann, dass der Arbeitstemperaturbereich erreicht wird.

Die Aufgabe wird durch die Gesamtheit der Merkmale der Ansprüche 1 und 5 gelöst. Der Kern der Erfindung besteht darin, die Sperrschichttemperatur durch Erzeugung von Wärme im Leistungshalbleiterbauelement selbst zu erhöhen. Da die Wärme direkt dort erzeugt wird, wo sie gebraucht wird, entfallen aufwendige Umrüstungen des Gesamtsystems und der Aufbau des Systems bleibt kompakt. Insbesondere lässt sich die Wärmeerzeugung gut steuern und dosieren.

Eine erste bevorzugte Ausgestaltung des Verfahrens nach der Erfindung ist dadurch gekennzeichnet, dass das Leistungshalbleiterbauelement zwischen der Kathode und dem Gate einen pn-Uebergang aufweist, und dass zur Erzeugung der Wärme der pn-Uebergang zwischen Gate und Kathode in Sperrrichtung im Lawinendurchbruchsbereich (Avalanche-Durchbruchsbereich) betrieben wird. Mit steigender Temperatur steigt die am pn-Uebergang abfallende Avalanche-Spannung. Die Zunahme der Avalanche-Spannung mit der Temperatur führt zu einer Homogenisierung des Stromflusses. Die Gefahr einer lokalen Ueberhitzung in dieser Betriebsart besteht somit nicht. Dies wurde experimentell bis zu sehr hohen Strömen verifiziert.

Da die Avalanche-Spannung mit der Sperrschichttemperatur Tⱼ zunimmt, ist es vorteilhaft, wenn gemäss einer zweiten Ausgestaltung der Erfindung dem pn-Uebergang ein vorgegebener Strom eingeprägt wird, und wenn die am pn-Uebergang abfallende Spannung zur Bestimmung der Temperatur des pn-Uebergangs gemessen und ausgewertet wird. Aus der Spannungsmessung kann dann der Zeitpunkt ermittelt werden, zu dem die minimale Sperrschichttemperatur des Bauelements erreicht ist und das Bauelement gefahrlos eingeschaltet werden kann.

Die erfindungsgemässe Vorrichtung zeichnet sich vorzugsweise dadurch aus, dass die Wärmeerzeugungsmittel eine zwischen das Gate und die Kathode geschaltete, in Sperrrichtung des zwischen Gate und Kathode liegenden pn-Uebergangs gepolte Stromquelle umfassen, dass zwischen dem Gate und der Kathode einen Spannungsmesseinrichtung zur Messung der am pn-Uebergang im Lawinendurchbruchsbetrieb abfallenden Spannung angeordnet ist, dass zum Ansteuern des Leistungshalbleiterbauelements eine Ansteuerschaltung vorgesehen ist, und dass die Spannungsmesseinrichtung mit der Ansteuerschaltung in Wirkverbindung steht.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 1: die vereinfachte Beschaltung eines IGCT gemäss einem bevorzugten Ausführungsbeispiel der Erfindung; und
- Fig. 2: den prinzipiellen internen Vierschicht-Aufbau des IGCT-Bauelements aus Fig. 1 mit dem zur Wärmeerzeugung verwendeten pn-Uebergangs zwischen Gate und Kathode.

### WEGE ZUR AUSFÜHRUNG DER ERFINDUNG

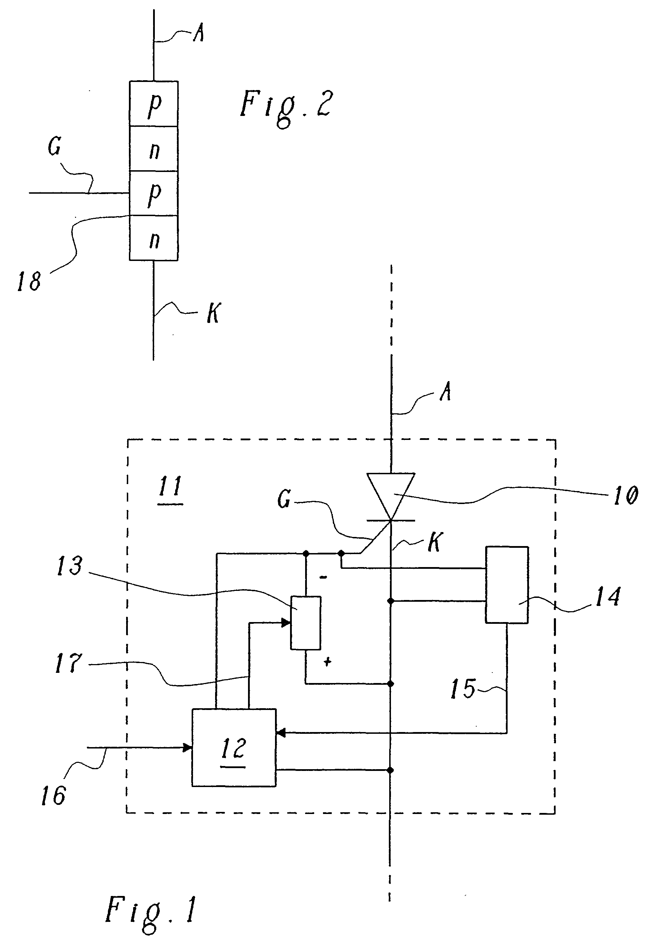

In Fig. 1 ist die vereinfachte Beschaltung eines IGCT gemäss einem bevorzugten Ausführungsbeispiel der Erfindung wiedergegeben. Der IGCT 11 umfasst einen GCT 10, der mit dem Symbol eines Thyristors dargestellt ist und eine Anode A, eine Kathode K und ein Gate G aufweist. Der prinzipielle innere Aufbau des GCT 10 ist in Fig. 2 dargestellt und zeigt die übliche Vierschicht-Anordnung aus aufeinanderfolgenden p- und n-Schichten. Der tatsächliche innere Aufbau des GCT 10 kann beispielsweise dem eingangs genannten Artikel von Harold M. Stillmann entnommen werden (dortige Fig. 4a). Innerhalb des IGCT 11 sind der GCT und eine niederdinduktive Ansteuerschaltung 12 zu einer baulichen Einheit zusammengefügt. Der innere Aufbau der Ansteuerschaltung kann beispielsweise aus Fig. 11 des eingangs genannten Datenblattes Doc. No.5SYA 1218-04 vom Feb. 99 entnommen werden. Die Ansteuerschaltung 12, deren beide Steuerausgänge am Gate G und an der Kathode K des GCT 10 liegen, erhält Steuerbefehle von aussen über eine erste Steuersignalleitung 16, z.B. einen Steuerbus. Sie schaltet den GCT ein und auch wieder aus, wobei der Kathodenstrom in sehr kurzer Zeit vollständig auf das Gate G kommutiert wird.

Der GCT 10 hat einen Arbeitstemperaturbereich für seine Sperrschichttemperatur (Junction-Temperatur) Tⱼ, der nach unten hin durch eine Minimaltemperatur begrenzt ist (beim eingangs genannten IGCT-Typ 5SHY 35L4502 der Anmelderin beträgt diese minimale Sperrschichttemperatur typischerweise 0°C). Herrschen in der Umgebung des Stromrichters oder eines anderen leistungselektronischen Systems, in dem der IGCT 11 eingesetzt ist, nun vor der Inbetriebnahme Temperaturen unterhalb der minimalen Sperrschichttemperatur (z.B. < 0°C), muss das Bauelement zunächst auf eine Sperrschichttemperatur vorgeheizt werden, die innerhalb des für den Betrieb zulässigen Sperrschichttemperaturbereichs liegt.

Dieses Vorheizen geschieht gemäss eines bevorzugten Ausführungsbeispiels der Erfindung dadurch, dass der zwischen Gate G und der Kathode K liegende pn-Uebergang 18 (Fig. 2) in Sperrrichtung mittels eines eingeprägten Stromes im Lawinendurchbruchsbereich betrieben wird. Der eingeprägte Strom wird von einer Stromquelle 13 geliefert, die zwischen Gate G und Kathode K geschaltet ist. Die im Lawinendurchbruchsbetrieb freigesetzte Wärmeenergie heizt den Wafer des GCT 10 soweit vor, dass die minimale Sperrschichttemperatur überschritten wird und der GCT gefahrlos eingeschaltet werden kann. Der Stromfluss in Sperrrichtung der Gate-Kathoden-Strecke beeinflusst dabei das Sperrverhalten der Kathoden-Anoden-Strecke nicht und der GCT behält in diesem Modus seine volle Blockierfähigkeit.

Da die am pn-Uebergang 18 bzw. an der Gate-Kathoden-Strecke abfallende Avalanche-Spannung mit der Sperrschichttemperatur Tⱼ zunimmt, kann eine Messung dieser Spannung den Zeitpunkt ermitteln, zu dem die minimale Sperrschichttemperatur des GCT 10 bzw. IGCT 11 erreicht wird und somit der GCT 10 gefahrlos eingeschaltet werden kann. In der Schaltung nach Fig. 1 ist dazu eine Spannungsmesseinrichtung 14 vorgesehen, die zwischen Gate G und Kathode K geschaltet ist und die an dieser Strecke abfallende Spannung misst. Erreicht die gemessene Spannung einen Wert, welcher der minimalen Sperrschichttemperatur des Bauelements entspricht, wird über eine Signalleitung 15 ein Freigabebefehl an die Ansteuerschaltung 12 abgegeben, der den Betrieb des GCT 10 freigibt. Die Stromquelle 13 kann dann über eine zweite Steuersignalleitung 17 von der Ansteuerschaltung 12 ausgestellt werden.

Die beschriebene Funktion der Vorheizung kann mit geringem Aufwand in die Ansteuerung des GCT 10 integriert werden. Auf diese Weise ist es leicht möglich, den spezifizierten Umgebungstemperaturbereich einer mit den Bauelementen ausgerüsteten Anlage zu tieferen Temperaturen hin zu erweitern. Selbstverständlich kann die Vorheizung auch bei anderen geeigneten Leistungshalbleiterbauelementen eingesetzt werden.

### BEZUGSZEICHENLISTE

- 10: GCT (Gate-Commutated Thyristor)
- 11: IGCT (Integrated Gate-Commutated Thyristor)
- 12: Ansteuerschaltung
- 13: Stromquelle
- 14: Spannungsmesseinrichtung
- 15: Signalleitung
- 16,17: Steuersignalleitung
- 18: pn-Uebergang
- A: Anode
- G: Gate
- K: Kathode
- Tⱼ: Sperrschichttemperatur

## Patentansprüche

1. Verfahren zum Betreiben eines eine Anode (A) und eine Kathode (K) aufweisenden, über ein Gate (G) abschaltbaren Leistungshalbleiterbauelements (10, 11), insbesondere eines GCTs (10) bzw. IGCTs (11), bei welchem Leistungshalbleiterbauelement (10, 11) die Sperrschichttemperatur (Tⱼ) einen Arbeitstemperaturbereich mit einer Minimaltemperatur aufweist, der den Arbeitstemperaturbereiches des Leistungshalbleiterbauelements (10, 11) bestimmt, **dadurch gekennzeichnet, dass** zur Erweiterung eines Arbeitstemperaturbereiches des Leistungshalbleiterbauelements (10, 11) vor dem ersten Einschalten des Leistungshalbleiterbauelements (10, 11) die Sperrschichttemperatur (Tⱼ) durch Erzeugung von Wärme im Leistungshalbleiterbauelement (10, 11) selbst erhöht wird.

2. Verfahren nach Anspruch 1, **dadurch gekennzeichnet, dass** das Leistungshalbleiterbauelement (10, 11) zwischen der Kathode (K) und dem Gate (G) einen pn-Uebergang (18) aufweist, und dass zur Erzeugung der Wärme der pn-Uebergang (18) zwischen Gate (G) und Kathode (K) in Sperrrichtung im Lawinendurchbruchsbereich betrieben wird.

3. Verfahren nach Anspruch 2, **dadurch gekennzeichnet, dass** dem pn-Uebergang (18) eine vorgegebener Strom eingeprägt wird, und dass die am pn-Uebergang (18) abfallende Spannung zur Bestimmung der Temperatur (Tⱼ) des pn-Uebergangs (18) gemessen und ausgewertet wird.

4. Verfahren nach Anspruch 3, **dadurch gekennzeichnet, dass** nach Erreichen der Minimaltemperatur des ersten Arbeitstemperaturbereiches das Leistungshalbleiterbauelement (10, 11) für den Schaltbetrieb freigegeben wird.

5. Vorrichtung zur Durchführung des Verfahrens nach einem der Ansprüche 1 bis 4, **dadurch gekennzeichnet, dass** am Leistungshalbleiterbauelement (10, 11) Mittel zur Erzeugung von Wärme im Leistungshalbleiterbauelement (10, 11) angeordnet sind.

6. Vorrichtung nach Anspruch 5, **dadurch gekennzeichnet, dass** die Wärmeerzeugungsmittel eine zwischen das Gate (G) und die Kathode (K) geschaltete, in Sperrrichtung des zwischen Gate (G) und Kathode (K) liegenden pn-Uebergangs (18) gepolte Stromquelle (13) umfassen.

7. Vorrichtung nach Anspruch 6, **dadurch gekennzeichnet, dass** zwischen dem Gate (G) und der Kathode (K) einen Spannungsmesseinrichtung (14) zur Messung der am pn-Uebergang (18) im Lawinendurchbruchsbetrieb abfallenden Spannung angeordnet ist, dass zum Ansteuern des Leistungshalbleiterbauelements (10, 11) eine Ansteuerschaltung (12) vorgesehen ist, und dass die Spannungsmesseinrichtung (14) mit der Ansteuerschaltung (12) in Wirkverbindung steht.
